(19) Europäisches Patentamt
European Patent Office
Office européen des brevets

(11) **EP 1 588 483 B1**

(12) **EUROPÄISCHE PATENTSCHRIFT**

(45) Veröffentlichungstag und Bekanntmachung des Hinweises auf die Patenterteilung:
**29.02.2012 Patentblatt 2012/09**

(21) Anmeldenummer: **04705406.9**

(22) Anmeldetag: **27.01.2004**

(51) Int Cl.:
***H03B 21/02*** *(2006.01)*

(86) Internationale Anmeldenummer:
**PCT/EP2004/000677**

(87) Internationale Veröffentlichungsnummer:
**WO 2004/068697 (12.08.2004 Gazette 2004/33)**

(54) **VORRICHTUNG UND VERFAHREN ZUR FREQUENZSYNTHESE**

DEVICE AND METHOD FOR CARRYING OUT FREQUENCY SYNTHESIS

DISPOSITIF ET PROCEDE DE SYNTHESE DE FREQUENCES

(84) Benannte Vertragsstaaten:
**DE FR GB**

(30) Priorität: **29.01.2003 DE 10303405**

(43) Veröffentlichungstag der Anmeldung:
**26.10.2005 Patentblatt 2005/43**

(73) Patentinhaber: **Infineon Technologies AG
85579 Neubiberg (DE)**

(72) Erfinder: **DA DALT, Nicola
9500 Villach (AT)**

(74) Vertreter: **Banzer, Hans-Jörg et al
Kraus & Weisert
Patent- und Rechtsanwälte
Thomas-Wimmer-Ring 15
80539 München (DE)**

(56) Entgegenhaltungen:
**EP-A- 0 430 493          GB-A- 2 002 157
US-A- 4 658 406          US-A- 5 781 459
US-A- 5 825 253          US-A1- 2001 050 598
US-A1- 2002 158 696**

**Beschreibung**

Die vorliegende Erfindung bezieht sich auf eine Vorrichtung und ein Verfahren zur Frequenzsynthese, insbesondere zur Frequenzsynthese unter Verwendung von digital gesteuerten Oszillatoren.

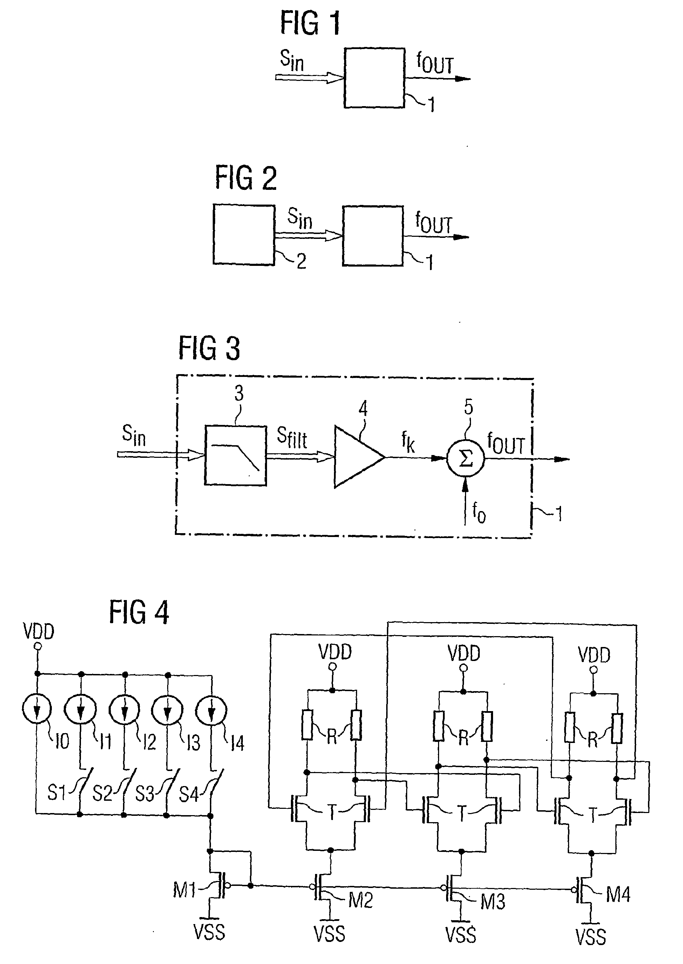

In der Halbleiterelektronik werden häufig Oszillatoren verwendet, welche nur bestimmte Frequenzen erzeugen können. Ein Beispiel hierfür sind digital gesteuerte Oszillatoren ("Digitally Controlled Oscillator", DCO). Ein solcher digital gesteuerter Oszillator ist beispielhaft in Figur 1 dargestellt. Dem digital gesteuerten Oszillator 1 wird dabei ein Parameter $s_{in}$ zugeführt, welcher nur eine endliche Anzahl diskreter Werte annehmen kann. Der Parameter kann irgend eine physikalische Größe sein, wie Strom, Spannung, Kapazität, Induktivität, Widerstand und dergleichen. Der Wert, der von diesem Parameter angenommen wird, ist üblicherweise durch den Status (Wert) eines digitalen Busses bestimmt. Im Folgenden werden die verschiedenen möglichen Werte des digitalen Busses als digitale Wörter bezeichnet und mit D1, D2,..., DN bezeichnet. Die Menge aller digitalen Wörter wird als S(D) = {D1,D2,...,DN} bezeichnet. Einem spezifischen Wert des Eingangsparameters $s_{in}$, also einem spezifischen digitalen Wort aus der Menge S(D), ist eineindeutig eine Ausgangsfrequenz des Ausgangssignals $F_{OUT}$ des digital gesteuerten Oszillators 1 zugeordnet. Daraus ergibt sich, dass der digital gesteuerte Oszillator nur eine diskrete Menge von Ausgangsfrequenzen erzeugen kann. Diese Frequenzen werden im Folgenden mit f1, f2,..., fN bezeichnet, und die entsprechende Menge aller möglichen Frequenzen wird mit S(f) bezeichnet. Es wird angenommen, dass die Frequenz fi dem digitalen Wort Di zugeordnet ist.

Bei manchen Anwendungen kann es vorkommen, dass eine Frequenz von dem digital gesteuerten Oszillator erzeugt werden soll, welche nicht in der Menge S(f) enthalten ist. Beispiel hierfür ist eine Regelschleife, bei der die Ausgangsfrequenz des digital gesteuerten Oszillators auf ein Vielfaches einer bestimmten Referenzfrequenz geregelt werden soll, beispielsweise durch Benutzung einer Phasenregelschleife ("Phase Locked Loop", PLL). Diese Referenzfrequenz oder ihre Vielfachen sind im Allgemeinen unabhängig von den Frequenzen, welche von dem digital gesteuerten Oszillator erzeugt werden können, und stimmen daher im Allgemeinen nicht mit Elementen der Menge S(f) überein.

Bisher wurde dieses Problem durch Techniken gelöst, welche üblicherweise in größerem Umfang analoge Schaltkreise benutzen. Ein Beispiel hierfür ist die N-Frequenzteilersynthese, welche für drahtlose Datenübertragung benutzt wird. Dabei wird ein Oszillator, in diesem Fall ein spannungsgesteuerter Oszillator, von analogen Steuersignalen angesteuert. Die gewünschte Ausgangsfrequenz wird erzeugt, indem ein N-Frequenzteiler im Rückkopplungspfad der Frequenzsynthesevorrichtung benutzt wird. Üblicherweise wird dabei das Modul des N-Frequenzteilers von einem Delta-Sigma-Modulator höherer Ordnung (≥ 2) digital gesteuert, um störende Anteile des Ausgangsspektrums der Synthesevorrichtung zu verringern. Diese Lösung erfordert jedoch die Verwendung analoger Schaltkreise mit den typischen damit einhergehenden Problemen. Ein Beispiel hierfür sind Änderungen in der Verstärkung aufgrund von Leistungs-, Spannungs- oder Temperaturänderungen. Zudem kann diese Lösung nicht direkt auf digitale Frequenzsynthesearchitekturen, bei denen kein Rückkopplungspfad vorhanden ist, übertragen werden.

Die Patentschrift US5781459 offenbart eine Vorrichtung zur Frequenzsynthese, umfassend einen Oszillator welcher zur Erzeugung eines an einem Ausgang abgreifbaren Ausgangssignals mit einer Frequenz aus einer Menge von zwei möglichen Ausgangsfrequenzen ansteuerbar sind. der Oszillator ist derart ansteuert, dass diese im Wechsel zwei verschiedene Ausgangsfrequenzen aus der Menge möglicher Ausgangsfrequenzen derart erzeugen, dass der Mittelwert der erzeugten Ausgangsfrequenzen über einen bestimmten Zeitraum im Wesentlichen die gewünschte Frequenz ist.

Es ist daher die Aufgabe der vorliegenden Erfindung, eine Vorrichtung und ein Verfahren bereitzustellen, womit eine möglichst genaue Frequenzsynthese mit geringem Aufwand realisiert werden kann und insbesondere der Einsatz einer digitalen Steuerung möglich ist.

Diese Aufgabe wird gelöst durch eine Vorrichtung nach Anspruch 1 bzw. ein Verfahren nach Anspruch 10. Die Unteransprüche definieren bevorzugte oder vorteilhafte Ausführungsbeispiele der Erfindung.

Erfindungsgemäß wird vorgeschlagen, Oszillatormittel, welche zur Erzeugung einer an einem Ausgang abgreifbaren Ausgangsfrequenz aus einer Menge von mindestens zwei möglichen Ausgangsfrequenzen ansteuerbar sind, so anzusteuern, dass die Oszillatormittel zur Erzeugung einer gewünschten Frequenz, welche nicht in der Menge möglicher Ausgangsfrequenzen enthalten ist, mindestens zwei verschiedene Ausgangsfrequenzen aus der Menge möglicher Ausgangsfrequenzen im Wechsel derart erzeugen, dass der Mittelwert der erzeugten Ausgangsfrequenzen über einen Zeitraum im Wesentlichen die gewünschte Frequenz ist.

Der Wechsel der mindestens zwei erzeugten Ausgangsfrequenzen erfolgt dabei bevorzugt mit einer mittleren Frequenz, welche größer ist als der Kehrwert des Zeitraums, über welchen der Mittelwert gebildet wird. Die Oszillatormittel können dabei einen digital gesteuerten Oszillator umfassen oder durch ihn gebildet sein. Es ist aber beispielsweise auch denkbar, dass die Oszillatormittel aus mehreren einzelnen Oszillatoren bestehen, welche jeweils nur eine einzige Frequenz erzeugen.

Dabei ist die Frequenz, mit der der Wechsel der mindestens zwei Ausgangsfrequenzen vorgenommen wird, im Wesentlichen unabhängig von den Ausgangsfrequenzen. Sie kann insbesondere - bei Ausnutzung von Mittelungseffekten - kleiner als die mindestens zwei Ausgangsfrequenzen sein, aber auch größer als diese gewählt werden.

Die Oszillatormittel bzw. der digital gesteuerte Oszillator können dabei beispielsweise einen Ringoszillator umfassen, welchem zur Ansteuerung ein Strom aus einer Menge von möglichen Strömen zuführbar ist. Alternativ oder zusätzlich kann ein LC-Glied vorhanden sein, durch welches die Ausgangsfrequenz bestimmbar ist. Dabei kann das LC-Glied eine oder mehrere schaltbare Kapazitäten umfassen, so dass die Gesamtkapazität des LC-Gliedes geändert werden kann und somit die Ausgangsfrequenz gesteuert werden kann. Alternativ kann die Kapazität des LC-Gliedes eine oder mehrere Varaktordioden umfassen, durch deren Ansteuerung ebenfalls die Gesamtkapazität des LC-Gliedes geändert werden kann. Zusätzlich kann die Vorrichtung einen oder mehrere mit dem Ausgang der Oszillatormittel verschaltete Frequenzteiler umfassen.

Die Erfindung wird im Folgenden unter Bezugnahme auf die beigefügte Zeichnung anhand eines bevorzugten Ausführungsbeispiels näher erläutert. Es zeigen:

Figur 1 das Prinzip eines digital gesteuerten Oszillators,

Figur 2 den digital gesteuerten Oszillator aus Figur 1 mit einer Ansteuerung,

Figur 3 ein lineares Modell eines digital gesteuerten Oszillators,

Figur 4 eine mögliche Ausführungsform eines digital gesteuerten Oszillators,

Figur 5 eine zweite mögliche Ausführungsform eines digital gesteuerten Oszillators,

Figur 6 eine dritte mögliche Ausführungsform eines digital gesteuerten Oszillators,

Figur 7 ein Blockschaltbild einer erfindungsgemäßen Vorrichtung zur Durchführung von Schaltungssimulationen, und

Figuren 8a-8c simulierte Signalverläufe der in Figur 7 dargestellten Schaltung.

Figur 1 zeigt, wie Eingangs genau erläutert das Prinzip eines digital gesteuerten Oszillators 1. In Figur 2 ist gegenüber Figur 1 zusätzlich eine Steuervorrichtung 2 zur Ansteuerung des digital gesteuerten Oszillators 1 vorhanden. Bei der Steuervorrichtung kann es sich beispielsweise um einen digitalen Prozessor handeln, welcher den digital gesteuerten Oszillator 1 über einen digitalen Kontrollbus ansteuert. Über den digitalen Kontrollbus wird ein digitales Steuersignal $s_{in}$ an den digital gesteuerten Oszillator 1 gesendet. Dieses digitale Steuersignal $s_{in}$ kann Werte, beispielsweise Stromwerte, Spannungswerte oder Widerstandswerte, aus einer endlichen Menge möglicher Eingangssignale S(D) annehmen. In Abhängigkeit von dem Steuersignal $s_{in}$ erzeugt der digital gesteuerte Oszillator 1 ein Ausgangssignal $f_{OUT}$, dessen Frequenz in eineindeutiger Weise jeweils einem bestimmten Steuersignal $s_{in}$ aus der Menge S(D) zugeordnet ist. Daraus ist ersichtlich, dass die Ausgangsfrequenz ebenfalls aus einer endlichen Menge S(f) möglicher Ausgangsfrequenzen stammt.

Ist es nun nötig oder gewünscht, ein Ausgangssignal $f_{OUT}$ mit einer Frequenz zu erzeugen, welche nicht in der Menge S(f) enthalten ist, steuert erfindungsgemäß die Steuervorrichtung 2 den digital gesteuerten Oszillator 1 so an, dass dieser mindestens zwei verschiedene Frequenzen aus der Menge S(f) erzeugt, so dass das zeitliche Mittel der Frequenz des Ausgangssignals $f_{OUT}$ genau diese gewünschte Frequenz ergibt.

Die zeitliche Mittelung erfolgt dabei über einen Zeitraum $T_{av}$. Der Wert von $T_{av}$ hängt von der jeweiligen Anwendung ab. Der kleinstmögliche Wert für $T_{av}$ ist eine Periode des Ausgangstaktes des digital gesteuerten Oszillators.

Als vereinfachtes Beispiel für eine erfindungsgemäße Vorrichtung kann dabei ein digital gesteuerter Oszillator dienen, welcher von einem Ein-Bit-Bus kontrolliert wird, durch den zwei Werte des Steuersignals $s_{in}$, nämlich D1=0 und D2=1, übertragen werden können. Der digital gesteuerte Oszillator kann damit zur Ausgabe von nur zwei Frequenzen, nämlich f1 und f2 angesteuert werden. Wenn nun die Erzeugung einer Frequenz, die genau zwischen diesen beiden Frequenzen f1 und f2 liegt, nämlich (f1+f2)/2, gewünscht wird, kann dies realisiert werden, indem das Steuersignal $s_{in}$ mit einem Tastverhältnis von 50% zwischen den Werten D1 und D2 wechselt.

Im Allgemeinen kann eine gewünschte Frequenz auch durch Mittelung über mehr als zwei Frequenzen erzeugt werden, indem das Steuersignal $s_{in}$ zwischen den entsprechenden Werten aus der Menge S(D) wechselt.

Um eine korrekte Ausgangsfrequenz zu erhalten, muss eine mittlere Umschaltfrequenz $f_s$ zwischen den verschiedenen nötigen Steuersignalen $s_{in}$ aus der Menge S(D) größer sein als das Inverse des Mittelungszeitraums $T_{av}$. Wie viel größer hängt auch davon ab, wie schnell das Ausgangssignal $f_{OUT}$ des digital gesteuerten Oszillators auf Änderungen des Steuersignals $s_{in}$ reagiert.

Diese Trägheit kann anhand des in Figur 3 dargestellten linearen Modells eines digital gesteuerten Oszillators verstanden werden. Bei diesem Modell wird das Steuersignal $s_{in}$ zunächst einem Tiefpassfilter 3 zugeführt, welcher aus dem Steuersignal $s_{in}$ ein gefiltertes Steuersignal $s_{filt}$ herstellt. In dem linearen Modell wird davon ausgegangen, dass die Frequenz des Ausgangssignals $f_{OUT}$ linear von dem gefilterten Eingangssignal $s_{filt}$ abhängen soll. Der lineare Oszillator multipliziert demnach vereinfacht dargestellt das Signal $s_{filt}$ mit einer Konstante K, um ein Zwischensignal $f_k$ mit einer Zwi-

schenfrequenz zu erhalten. Um das Ausgangssignal $f_{OUT}$ zu erhalten, wird zu der Frequenz des Zwischensignals $f_k$ noch eine Frequenz $f_0$ addiert, welche der Frequenz des digital gesteuerten Oszillators entspricht, wenn das Steuersignal $s_{in}$ gleich null ist.

Die Trägheit des digital gesteuerten Oszillators hängt dabei von der Grenzfrequenz des Tiefpassfilters ab. Eine kleine Grenzfrequenz bedeutet eine große Trägheit bzw. einen großen intrinsischen Mittelungseffekt des digital gesteuerten Oszillators.

Wenn der Mittelungszeitraum $T_{av}$ nur eine Periode des Ausgangstaktes des digital gesteuerten Oszillators beträgt (keine Mittelung), dann muss der Wert von $s_{in}$ mehrmals während der Zeit $T_{av}$ geändert werden ($f_s$ >> $1/T_{av}$). In diesem Fall ist $f_s$ also größer als f1 und f2 des digital gestreuten Oszillators. Wenn der digital gesteuerte Oszillator träge genug ist, kann $f_s$ aufgrund des intrinsischen Mittelungseffekts des digital gesteuerten Oszillators reduziert werden und dabei - gegebenenfalls unter Ausnutzung von Mittelungseffekten von nachgeschalteten Frequenzteilern - auch kleiner oder wesentlich kleiner als die Frequenzen f1 und f2 werden, was bei hohen Frequenzen eine einfachere Ansteuerung erlaubt. Wenn der intrinsische Mittelungseffekt des digital gesteuerten Oszillators besonders groß ist, kann als Steuersignal $s_{in}$ auch ein Bitstrom verwendet werden, welcher nach dem Delta-Sigma-Prinzip erzeugt und gegebenenfalls rauschgeformt wurde. Das Hochfrequenzrauschen, das dabei entsteht, wird durch den Tiefpassfilter entfernt, bevor das Ausgangssignal $f_{OUT}$ erzeugt wird.

Im Folgenden sollen verschiedene Realisierungsmöglichkeiten für den digital gesteuerten Oszillator erläutert werden.

Figur 4 zeigt ein Ausführungsbeispiel eines digital gesteuerten Oszillators aufgrund eines Ringoszillators. Der eigentliche Ringoszillator wird dabei aus Transistoren T und Widerständen R als Kette hintereinander geschalteter Inverter gebildet. Die Frequenz des Ringoszillators wird dabei durch den Strom bestimmt, welcher durch die Transistoren T des Ringoszillators fließt. Dieser Strom wird durch eine Stromquelle 10 und durch Schalter S1-S4 schaltbare Stromquellen I1-I4 bestimmt. Der derart bestimmte Gesamtstrom wird durch den Stromspiegel M1-M4 auf den Ringoszillator übertragen. Die digitale Ansteuerung des derart ausgestalteten Oszillators geschieht dabei durch Öffnen und Schließen der Schalter S1-S4. Durch Schließen der Schalter S1-S4 wird der jeweilige Strom I1-I4 zum Mindeststrom 10 addiert.

Eine weitere Möglichkeit besteht darin, einen LC-Schwingkreis als digital gesteuerten Oszillator zu verwenden. Dabei wird die Oszillationsfrequenz durch die Werte der Induktivität L und der Gesamtkapazität C bestimmt. Als Ausgangsfrequenz $f_{OUT}$ ergibt sich dabei in erster Näherung der Wert $1/(2\pi \times \sqrt{LC})$.

Die digitale Steuerung der Ausgangsfrequenz kann dabei durch Variation der Gesamtkapazität C erfolgen. Wenn C nur eine endliche Anzahl von diskreten Werten annehmen kann, kann auch die Ausgangsfrequenz des digital gesteuerten Oszillators nur eine diskrete Anzahl von Werten annehmen.

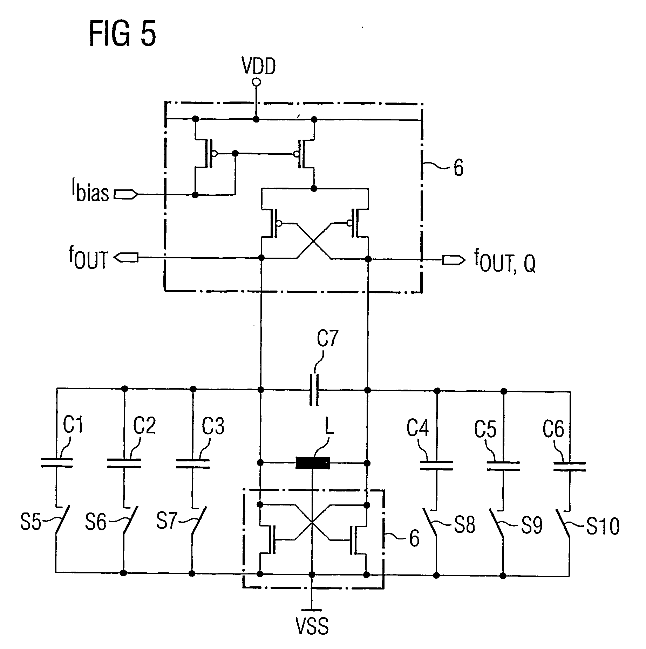

Ein erstes Beispiel hierfür ist in Figur 5 dargestellt. Die Gesamtkapazität C wird bei dem in Figur 5 dargestellten Oszillator durch die Kapazitäten C1-C7 gebildet. Dabei sind die Kapazitäten C1-C6 durch Schalter S5-S10 schaltbar. Somit kann die Gesamtkapazität durch Betätigung der Schalter variiert werden. Die Induktivität L bleibt dabei fest. Zusätzlich ist eine Ansteuerungsschaltung 6 vorhanden, welcher ein fester Strom $I_{bias}$ zugeführt wird. Diese dient dazu, im Schwingkreis auftretende Verluste zu kompensieren. Das Ausgangssignal kann dann an den mit $f_{OUT}$ oder $f_{OUT, Q}$ gekennzeichneten Anschlüssen abgegriffen werden.

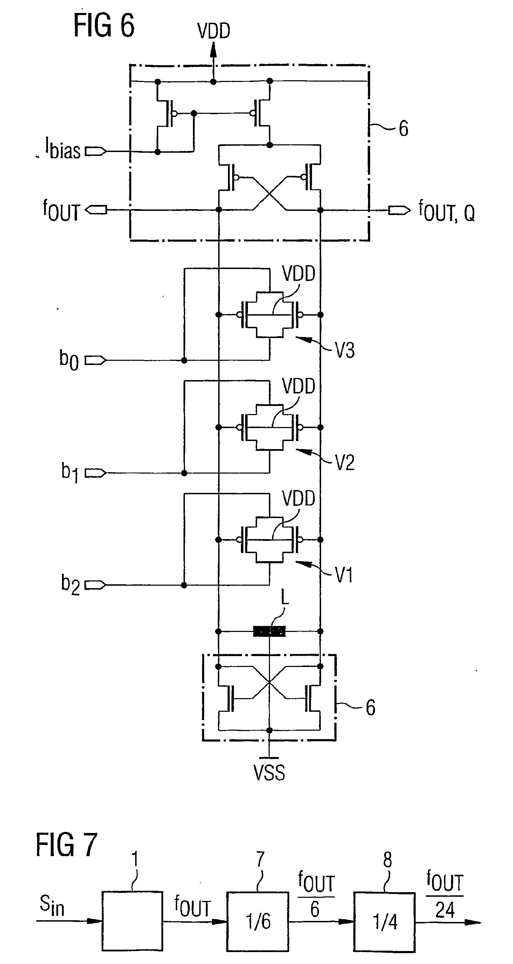

Ein ähnlicher Oszillator ist in Figur 6 dargestellt. Statt der Kapazitäten aus Figur 5 sind nun Varaktordioden V1-V3 vorhanden, deren Kapazität sich durch eine an den Anschlüssen $b_0$-$b_2$ angelegte Spannung steuern lässt. Somit kann die Gesamtkapazität wiederum eingestellt werden und die Ausgangsfrequenz des Oszillators gesteuert werden. Im übrigen ist der Aufbau des in Figur 6 dargestellten Oszillators identisch mit dem in Figur 5 dargestellten. Der Vorteil der in Figur 6 dargestellten Schaltung gegenüber der in Figur 5 dargestellten ist, dass keine Schalter benötigt werden.

Ein digital gesteuerter Oszillator analog dem in Figur 6 dargestellten wurde zur Durchführung von Simulationen benutzt. Die zur Simulation verwendete Struktur ist schematisch in Figur 7 dargestellt.

Es wird ein von einem Ein-Bit-Steuersignal $s_{in}$ digital gesteuerter Oszillator 1 auf Basis eines LC-Schwingkreises benutzt. Der digital gesteuerte Oszillator kann nur zwei Frequenzen erzeugen: 2,1 GHz und 2,18 GHz. Die Ausgangsfrequenz wird zunächst durch einen ersten Frequenzteiler 7 durch sechs geteilt und dann durch einen zweiten Frequenzteiler 8 nochmals durch vier geteilt, so dass die Frequenz insgesamt durch 24 geteilt wird. Demnach können mit der Anordnung insgesamt die beiden Frequenzen 87,5 MHz und 90,8 MHz erzeugt werden. Nun soll mit dieser Anordnung eine Frequenz von 89,2 MHz erzeugt werden, welche genau zwischen diesen beiden Frequenzen liegt. Dies kann erreicht werden, indem das Steuerbit zwischen den beiden Zuständen mit 50% Tastverhältnis umgeschaltet wird. In der im Folgenden dargestellten Simulation betrug die Umschaltzeit zwei Nanosekunden. Die Umschaltfrequenz $F_s$= 1/2ns =500MHz ist also wesentlich kleiner als die Frequenzen, welche vom digital gesteuerten Oszillator erzeugt werden.

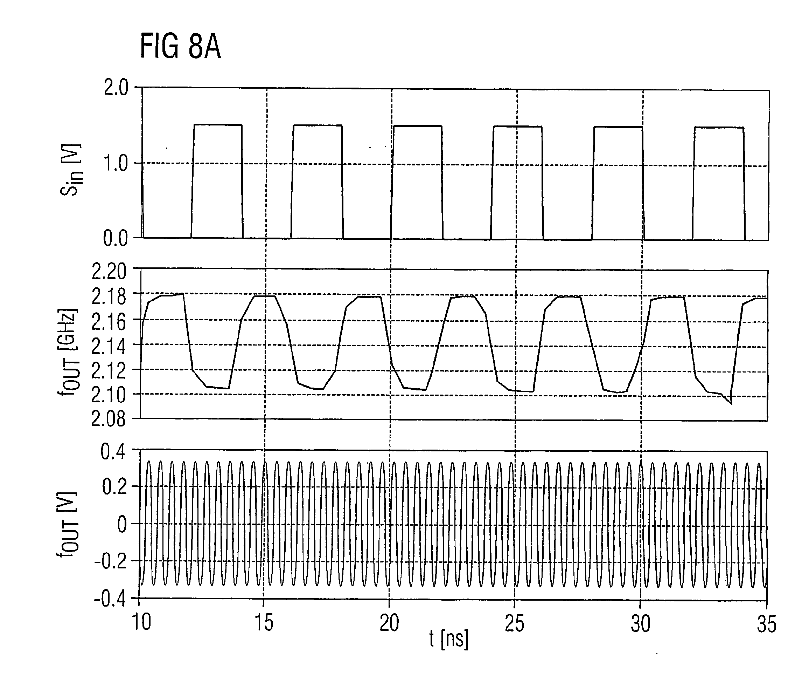

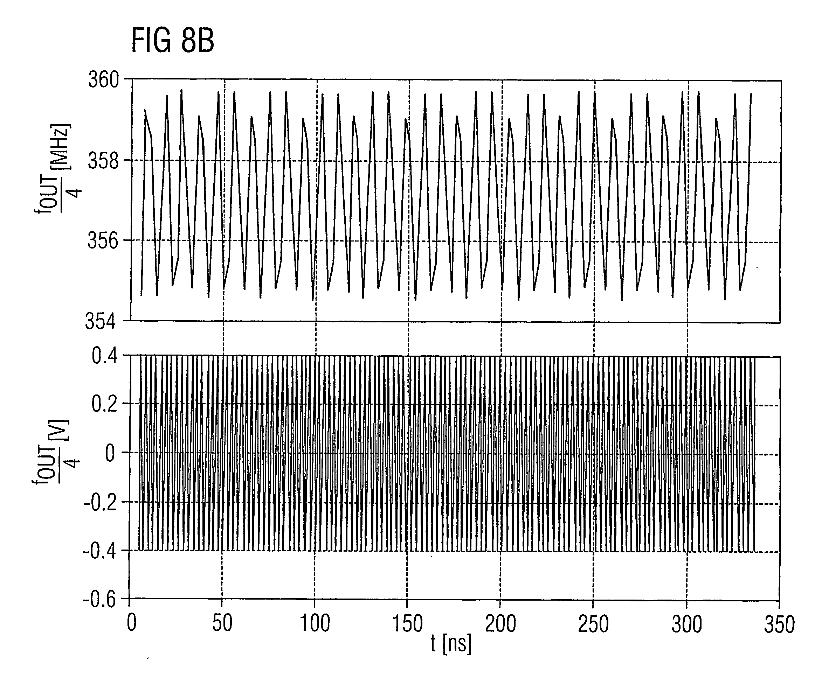

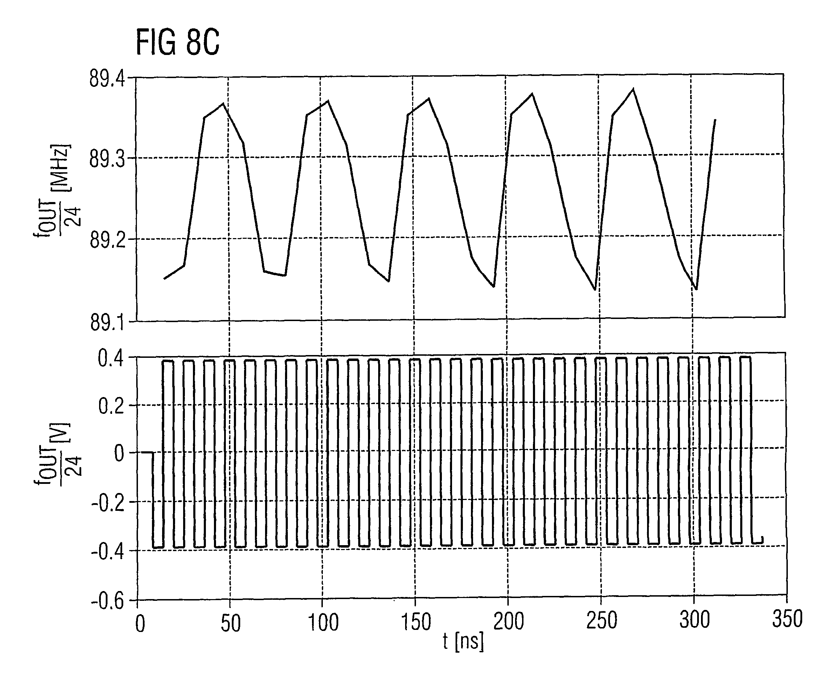

Figur 8 zeigt die Ergebnisse der Simulation. In Figur 8a ist der zeitliche Verlauf der Spannung des Steuersignals sowie der zeitliche Verlauf der Frequenz sowie der Spannung des von dem digital gesteuerten Oszillator erzeugten Signals $f_{OUT}$ dargestellt. In den Figuren 8b und 8c sind jeweils der zeitliche Verlauf der Frequenz und der Spannung des Signals nach dem ersten bzw. dem zweiten Frequenzteiler dargestellt. Wie in Figur 8c zu sehen, schwankt die Ausgangsfrequenz nur wenig um den gewünschten Wert von 89,2 MHz. Der relative Frequenzfehler am Ausgang des digital gesteuerten Oszillators beträgt 3,7%. Durch die Frequenzteiler wird der Mittelungszeitraum verlängert. Am Ausgang des zweiten Frequenzteilers beträgt der relative Frequenzfehler nur noch 0,22%. Durch eine kürzere Umschaltzeit könnte ein noch kleinerer Frequenzfehler erreicht werden. Durch die Ausnutzung der Mittelungseffekte der Frequenzteiler 7, 8 wird jedoch auch mit einer im Vergleich zu den Ausgangsfrequenzen des digital gesteuerten Oszillators langen Umschaltzeit ein gutes Ergebnis erreicht. Ein ähnliches Ergebnis ließe sich natürlich auch mit einem Oszilator erreichen, welcher - wie bereits beschrieben - eine große intrinsische Mittelung aufweist.

Damit ist gezeigt, dass durch eine erfindungsgemäße Vorrichtung bzw. ein erfindungsgemäßes Verfahren eine Ausgangsfrequenz erzeugt werden kann, welche nicht direkt einer von dem verwendeten Oszillator erzeugbaren Frequenz entspricht.

**Patentansprüche**

1. Vorrichtung zur Frequenzsynthese, umfassend Oszillatormittel (1), welche zur Erzeugung eines an einem Ausgang abgreifbaren Ausgangssignals ($f_{OUT}$) mit einer Frequenz aus einer Menge von mindestens zwei möglichen Ausgangsfrequenzen ansteuerbar sind, und
eine Steuervorrichtung (2) zur Ansteuerung der Oszillatormittel (1),
wobei die Steuervorrichtung (2) derart ausgestaltet ist, dass sie zur Erzeugung einer gewünschten Frequenz, welche nicht in der Menge möglicher Ausgangsfrequenzen enthalten ist, die Oszillatormittel (1) mit einem Delta-Sigma-Prinzip erzeugten Bitstrom derart ansteuert, dass diese im Wechsel mindestens zwei verschiedene Ausgangsfrequenzen aus der Menge möglicher Ausgangsfrequenzen derart erzeugen, dass der Mittelwert der erzeugten Ausgangsfrequenzen über einen bestimmten Zeitraum im Wesentlichen die gewünschte Frequenz ist, **dadurch gekennzeichnet dass**
die Steuervorrichtung (1) derart ausgestaltet ist, dass sie die Oszillatormittel (1) so ansteuert, dass der Wechsel der mindestens zwei erzeugten Ausgangsfrequenzen mit einer mittleren Frequenz erfolgt, welche größer ist als der Kehrwert des bestimmten Zeitraums,
wobei die Vorrichtung einen mit dem Ausgang der Oszillatormittel (1) verschalteten Frequenzteiler (7,8) umfasst, und
wobei der bestimmte Zeitraum durch einen Mittelungseffekt der Oszillatormittel und durch einen Mittelungseffekt des Frequenzteilers (7, 8) bestimmt ist.

2. Vorrichtung nach Anspruch 1,

**dadurch gekennzeichnet,**
**dass** die Steuervorrichtung (1) derart ausgestaltet ist, dass sie die Oszillatormittel (1) so ansteuert, dass der Wechsel der mindestens zwei erzeugten Ausgangsfrequenzen mit einer mittleren Frequenz erfolgt, welche größer ist als die mindestens zwei möglichen Ausgangsfrequenzen.

3. Vorrichtung nach Anspruch 1,
**dadurch gekennzeichnet,**
**dass** die Steuervorrichtung (1) derart ausgestaltet ist, dass sie die Oszillatormittel (1) so ansteuert, dass der Wechsel der mindestens zwei erzeugten Ausgangsfrequenzen mit einer mittleren Frequenz erfolgt, welche kleiner ist als die mindestens zwei möglichen Ausgangsfrequenzen.

4. Vorrichtung nach einem der vorhergehenden Ansprüche,
**dadurch gekennzeichnet,**
**dass** die Oszillatormittel einen digital gesteuerten Oszillator (1) umfassen.

5. Vorrichtung nach einem der vorhergehenden Ansprüche,
**dadurch gekennzeichnet,**
**dass** die Oszillatormittel einen Ringoszillator umfassen, wobei dem Ringoszillator zur Ansteuerung ein Strom aus einer Menge von möglichen Strömen ($I_0$, ..., $I_4$, ...) zuführbar ist.

6. Vorrichtung nach einem der vorhergehenden Ansprüche,
**dadurch gekennzeichnet,**
**dass** die Oszillatormittel (1) ein LC-Glied umfassen, durch welches die Ausgangsfrequenz bestimmbar ist.

7. Vorrichtung nach Anspruch 6,
**dadurch gekennzeichnet,**
**dass** eine Gesamtkapazität des LC-Gliedes mindestens eine Kapazität (C1-C6) umfasst, welche zur Ansteuerung des Oszillators schaltbar ist.

8. Vorrichtung nach Anspruch 6 oder 7,
**dadurch gekennzeichnet,**
**dass** die Kapazität des LC-Gliedes mindestens eine Varaktordiode (V1-V3) umfasst, welche zur Ansteuerung des Oszillators ansteuerbar ist.

9. Vorrichtung nach einem der vorhergehenden Ansprüche,
**dadurch gekennzeichnet,**
**dass** die Vorrichtung digital ausgestaltet ist.

10. Verfahren zur Frequenzsynthese mit zur Erzeugung eines Ausgangssignals ($f_{OUT}$) mit einer Ausgangsfrequenz aus einer Menge möglicher Ausgangsfrequenzen ansteuerbaren Oszillatormitteln,
wobei die Oszillatormittel zur Erzeugung einer gewünschten Frequenz, welche nicht in der Menge möglicher Ausgangsfrequenzen enthalten ist, mit einem nach dem Delta-Sigma-Prinzip erzeugten Bitstrom derart angesteuert werden, dass sie mindestens zwei verschiedene Ausgangsfrequenzen aus der Menge möglicher Ausgangsfrequenzen im Wechsel so erzeugen, dass der Mittelwert der mindestens zwei erzeugten Ausgangsfrequenzen über einen bestimmten Zeitraum der gewünschten Frequenz entspricht, **dadurch gekennzeichnet dass** der Wechsel der mindestens zwei erzeugten Ausgangsfrequenzen mit einer mittleren Frequenz erfolgt, welche größer als der Kehrwert des bestimmten Zeitraums ist, wobei das Ausgangssignal ($f_{OUT}$) einem Frequenzteiler (7, 8) zugeführt wird, und wobei der bestimmte Zeitraum durch einen Mittelungseffekt der Oszillatormittel und durch einen Mittelungseffekt des Frequenzteilers (7, 8) bestimmt ist.

11. Verfahren nach Anspruch 10,
    **dadurch gekennzeichnet,**
    **dass** der Wechsel der mindestens zwei erzeugten Ausgangsfrequenzen mit einer mittleren Frequenz erfolgt, welche größer als die mindestens zwei verschiedenen Ausgangsfrequenzen ist.

12. Verfahren nach Anspruch 10,
    **dadurch gekennzeichnet,**
    **dass** der Wechsel der mindestens zwei erzeugten Ausgangsfrequenzen mit einer mittleren Frequenz erfolgt, welche kleiner als die mindestens zwei verschiedenen Ausgangsfrequenzen ist.

13. Verfahren nach einem der Ansprüche 10 bis 12,
    **dadurch gekennzeichnet,**
    **dass** das Verfahren mit einer Vorrichtung nach einem der Ansprüche 1-9 durchgeführt wird.

**Claims**

1. Apparatus for frequency synthesis, comprising oscillator means (1), which can be actuated to produce an output signal ($f_{OUT}$), which can be tapped off at an output, at a frequency from a set of at least two possible output frequencies, and
   a control apparatus (2) for actuating the oscillator means (1),
   wherein the control apparatus (2) is designed such that it produces a desired frequency which is not included in the set of possible output frequencies by actuating the oscillator means (1) using a bit stream produced on the basis of the delta-sigma principle such that said oscillator means alternately produce at least two different output frequencies from the set of possible output frequencies such that the mean value of the output frequencies produced over a particular period is essentially the desired frequency, **characterized in that**
   the control apparatus (1) is designed such that it actuates the oscillator means (1) such that the alternation of the at least two output frequencies produced occurs at an average frequency which is higher than the reciprocal of the particular period,
   wherein the apparatus comprises a frequency divider (7, 8) which is connected to the output of the oscillator means (1), and
   wherein the particular period is determined by an averaging effect of the oscillator means and by an averaging effect of the frequency divider (7, 8).

2. Apparatus according to Claim 1,
   **characterized**
   **in that** the control apparatus (1) is designed such that it actuates the oscillator means (1) such that the alternation of the at least two output frequencies produced occurs at an average frequency which is higher than the at least two possible output frequencies.

3. Apparatus according to Claim 1,
   **characterized**
   **in that** the control apparatus (1) is designed such that it actuates the oscillator means (1) such that the alternation of the at least two output frequencies produced occurs at an average frequency which is lower than the at least two possible output frequencies.

4. Apparatus according to one of the preceding claims,
   **characterized**
   **in that** the oscillator means comprise a digitally controlled oscillator (1).

5. Apparatus according to one of the preceding claims,
   **characterized**
   **in that** the oscillator means comprise a ring oscillator, wherein the ring oscillator can be supplied with a current from a set of possible currents ($I_0$, ..., $I_4$, ...) for the purpose of actuation.

6. Apparatus according to one of the preceding claims,
   **characterized**
   **in that** the oscillator means (1) comprise an LC element which can determine the output frequency.

7. Apparatus according to Claim 6,
   **characterized**
   **in that** a total capacitance of the LC element comprises at least one capacitance (C1-C6) which can be switched to actuate the oscillator.

8. Apparatus according to Claim 6 or 7,
   **characterized**
   **in that** the capacitance of the LC element comprises at least one varactor diode (V1-V3) which can be actuated to actuate the oscillator.

9. Apparatus according to one of the preceding claims, **characterized in that** the apparatus is of digital design.

10. Method for frequency synthesis using oscillator means which can be actuated to produce an output signal ($f_{OUT}$) at an output frequency from a set of possible output frequencies, wherein the oscillator means are actuated to produce a desired frequency which is not included in the set of possible output frequencies using a bit stream produced on the basis of the delta-sigma principle such that they produce at least two different output frequencies from the set of possible output frequencies alternately such that the mean value of the at least two output frequencies produced over a particular period corresponds to the desired frequency, **characterized in that** the alternation of the at least two output frequencies produced occurs at an average frequency which is higher than the reciprocal of the particular period, wherein the output signal ($f_{OUT}$) is supplied to a frequency divider (7, 8), and wherein the particular period is determined by an averaging effect of the oscillator means and by an averaging effect of the frequency divider (7, 8).

11. Method according to Claim 10, **characterized in that** the alternation of the at least two output frequencies produced occurs at an average frequency which is higher than the at least two different output frequencies.

12. Method according to Claim 10, **characterized in that** the alternation of the at least two output frequencies produced occurs at an average frequency which is lower than the at least two different output frequencies.

13. Method according to one of Claims 10 to 12, **characterized in that** the method is carried out using an apparatus according to one of Claims 1-9.

**Revendications**

1. Dispositif de synthèse de fréquence, comprenant des moyens (1) formant oscillateur, qui, pour la production d'un signal ($f_{OUT}$) de sortie pouvant être prélevé sur une sortie, peuvent être excités par une fréquence parmi un nombre d'au moins deux fréquences de sortie possibles, et un dispositif (2) de commande pour l'excitation des moyens (1) formant oscillateur, dans lequel le moyen (2) de commande est tel qu'il excite, pour la production d'une fréquence souhaitée qui n'est pas du nombre des fréquences de sortie possibles, les moyens (1) formant oscillateur par un courant de bit produit suivant un principe delta-sigma, de manière à ce que ceux-ci produisent en alternance au moins deux fréquences de sortie différentes parmi le nombre de fréquences de sortie possibles, de manière à ce que la valeur moyenne des fréquences de sortie produites sur un laps de temps déterminé soit sensiblement la fréquence souhaitée, **caractérisé en ce que** le dispositif (1) de commande est tel qu'il excite les moyens (1) formant oscillateur, **en ce que** l'alternance des au moins deux fréquences de sortie produites s'effectue avec une fréquence moyenne qui est plus grande que l'inverse du laps de temps déterminé, dans lequel le dispositif comprend un diviseur (7, 8) de fréquence câblé avec la sortie des moyens (1) formant oscillateur, et dans lequel le laps de temps déterminé est déterminé par un effet de formation de moyenne des moyens formant oscillateur et par un effet de formation de moyenne du diviseur (7, 8) de fréquence.

2. Dispositif suivant la revendication 1, **caractérisé en ce que** le dispositif (1) de commande est tel qu'il excite les moyens (1) formant oscillateur, de manière à ce que l'alternance des au moins deux fréquences de sortie produites s'effectue avec une fréquence moyenne qui est plus grande que les au moins deux fréquences de sortie possibles.

3. Dispositif suivant la revendication 1, **caractérisé en ce que** le dispositif (1) de commande est tel qu'il excite les moyens (1) formant oscillateur, de manière à ce que l'alternance des au moins deux fréquences de sortie produites s'effectue avec une fréquence moyenne qui est plus petite que les au moins deux fréquences de sortie possibles.

4. Dispositif suivant l'une des revendications précédentes, **caractérisé en ce que** les moyens formant oscillateur comprennent un oscillateur (1) commandé numériquement.

5. Dispositif suivant l'une des revendications précédentes, **caractérisé en ce que** les moyens formant oscillateur comprennent un oscillateur annulaire, un courant parmi un nombre de courants ($I_0$, ..., 14, ...) possibles étant envoyé à l'oscillateur annulaire pour l'excitation.

**6.** Dispositif suivant l'une des revendications précédentes, **caractérisé en ce que** les moyens (1) formant oscillateur comprennent un élément LC, par lequel la fréquence de sortie peut être déterminée.

**7.** Dispositif suivant la revendication 6, **caractérisé en ce qu'**une capacité globale de l'élément LC comprend au moins une capacité (C1 à C6), qui peut être mise en circuit pour l'excitation de l'oscillateur.

**8.** Dispositif suivant la revendication 6 ou 7, **caractérisé en ce que** la capacité de l'élément LC comprend au moins une diode (V1 à V3) formant varacteur, qui peut être excitée pour l'excitation de l'oscillateur.

**9.** Dispositif suivant l'une des revendications précédentes, **caractérisé en ce que** le dispositif est numérique.

**10.** Procédé de synthèse de fréquences ayant des moyens formant oscillateur pouvant être excités pour la production d'un signal ($f_{OUT}$) de sortie ayant une fréquence de sortie parmi un certain nombre de fréquences de sortie possibles, dans lequel les moyens oscillateurs sont, pour la production d'une fréquence souhaitée qui n'est pas du nombre des fréquences de sortie possibles, excités par un courant de bit produit suivant le principe delta-sigma, de manière à ce qu'ils produisent en alternance au moins deux fréquences de sortie différentes parmi le nombre de sorties possibles, en ce que la valeur moyenne des au moins deux fréquences de sortie produites correspond sur un laps de temps déterminé à la fréquence souhaitée, **caractérisé en ce que** l'alternance des au moins deux fréquences de sortie produites s'effectue avec une fréquence moyenne qui est plus grande que l'inverse du laps de temps déterminé, le signal ($f_{OUT}$) de sortie étant envoyé à un diviseur (7, 8) de fréquence, et dans lequel on détermine le laps de temps déterminé par un effet de formation de moyenne des moyens formant oscillateur et par un effet de formation de moyenne du diviseur (7, 8) de fréquence.

**11.** Procédé suivant la revendication 10, **caractérisé en ce que** l'alternance des au moins deux fréquences de sortie produites s'effectue avec une fréquence moyenne qui est plus grande que les au moins deux fréquences de sortie différentes.

**12.** Procédé suivant la revendication 10, **caractérisé en ce que** l'alternance des au moins deux fréquences de sortie produites s'effectue avec une fréquence moyenne qui est plus petite que les au moins deux fréquences de sortie différentes.

**13.** Procédé suivant l'une des revendications 10 à 12, **caractérisé en ce qu'**on effectue le procédé par un dispositif suivant l'une des revendications 1 à 9.

# FIG 1

# FIG 2

# FIG 3

# FIG 4

# FIG 5

FIG 6

VDD

$I_{bias}$

$f_{OUT}$

$f_{OUT, Q}$

6

VDD

V3

$b_0$

VDD

V2

$b_1$

VDD

V1

$b_2$

L

6

VSS

FIG 7

$S_{in}$ → 1 → $f_{OUT}$ → 7 | 1/6 → $\dfrac{f_{OUT}}{6}$ → 8 | 1/4 → $\dfrac{f_{OUT}}{24}$

## FIG 8A

FIG 8B

EP 1 588 483 B1

FIG 8C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5781459 A